# EUROPÄISCHE PATENTANMELDUNG

(11) **EP 1 601 025 A2**
(43) Veröffentlichungstag der Anmeldung: **30.11.2005**
(21) Anmeldenummer: 05008240.3
(22) Anmeldetag: 15.04.2005
(51) Int. Cl.: H01L 31/052, H01L 31/0203, H01L 31/024

(54) **Solarmodul mit einem Substratträger aus Keramik**

(30) Priorität: 29.05.2004 DE 202004008563 U
(71) Anmelder: IXYS Semiconductor GmbH, D-68623 Lampertheim (DE)
(72) Erfinder: Strauch, Gerhard, Dr.rer.nat., 68642 Bürstadt (DE); Sperner, Andreas, Dipl.-Ing., 61462 Königstein/Ts. (DE)
(74) Vertreter: Luderschmidt, Schüler & Partner GbR

(57) **Zusammenfassung**

Das erfindungsgemäße Solarmodul weist ein Trägersubstrat (10) mit einer Anordnung von mindestens einer Solarzelle (40) auf der Oberseite (110) des Trägersubstrates, die mit einem transparenten, die Solarzelle abdeckenden, Kunststoff (50) vergossen ist, und eine als Kühlfläche fungierende ebene Unterseite (120) zur thermischen Ankopplung an einen Kühlkörper (130) auf, wobei das Trägersubstrat ein beidseitig mit Metall beschichtetes Keramiksubstrat ist.

## Beschreibung

Die Erfindung betrifft die Gestaltung von Solarmodulen, die in der Photovoltaik zur Umwandlung von kurzwelliger elektromagnetischer Strahlungsenergie in elektrische Energie unter Ausnutzung des photovoltaischen Effektes verwendet werden. Solarmodule weisen eine Anordnung von auf ein Trägersubstrat gelöteten Solarzellen auf.

Bekannt sind bislang Solarzellenanordnungen auf PCB Basis, wobei die Solarzellen auf Leiterplatten, bestehend aus Kunststoff oder aus Epoxydharz getränkten Glasfasern, aufgebracht sind, wobei letztere heute vorwiegend üblich sind. Die Bezeichnung PCB ist die in der Elektronik gebräuchliche Abkürzung für Printed Circuit Board.

Eine negative den PCB basierten Solarzellenanordnungen anhaftende Eigenschaft ist der relativ hohe thermische Widerstand, der mit einer relativ schlechten Wärmeleitung einhergeht. Dadurch bedingt erwärmen sich PCB basierte Solarmodule bei Sonneneinstrahlung stark auf. Zur Kühlung wird ein derartiges Solarmodul an der als Kühlfläche fungierenden ebenen Unterseite mit einem Kühlkörper verbunden.

Trotz der thermischen Ankopplung an einen Kühlkörper verbleibt die Kühlung des Solarmoduls gering. Die Erwärmung des Solarmoduls bedingt die Reduktion der Ausgangsspannung, und in Verbindung damit auch Leistungs- und Wirkungsgradverluste.

Solarmodule unterliegen, ähnlich wie Halbleiterbauelemente, einer Temperaturwechselbeanspruchung, die die Lebensdauer - darunter versteht man die Anzahl der möglichen Schaltzyklen - stark beeinflusst, wobei die Lebensdauer des Solarmoduls mit steigender Amplitude der Temperaturschwankungen während der Zyklen abnimmt.

Ein weiterer Nachteil gängiger PCB basierter Solarmodule liegt in der starken Verformung der Module infolge der Erwärmung, was zu thermischen Verspannungen zwischen den Schichten des Solarmoduls, und letztlich zu Materialermüdung und Verschleiß führt.

Zur Steigerung der Ausgangsleistung eines Solarmoduls werden bei räumlich begrenzten Anwendungen, z.B. bei kleinen kompakten Ladegeräten, Funk-Sensoren, etc., optische Hilfsmittel eingesetzt, die das einfallende Licht um ein Vielfaches verstärken. Man spricht hierbei auch von sogenannten Konzentratoranwendungen.

Wegen der zuvor beschriebenen, die Lebensdauer beeinflussenden Merkmale, sind PCB basierte Solarmodule für Konzentratoranwendungen ungeeignet.

Der Erfindung liegt daher die Aufgabe zugrunde, die thermischen Eigenschaften des Solarmoduls zu verbessern, um die Kühlung des Solarmoduls durch thermische Ankopplung an einen Kühlköper zu optimieren.

Bei dem erfindungsgemäßen Solarmodul wird diese Aufgabe durch ein Trägersubstrat mit einer Anordnung von mindestens einer Solarzelle auf der Oberseite des Trägersubstrates gelöst, die mit einem transparenten, die Solarzelle/ -zellen abdeckenden, Kunststoff vergossen ist, und eine als Kühlfläche fungierende ebene Unterseite zur thermischen Ankopplung an einen Kühlkörper aufweist, wobei das Trägersubstrat ein beidseitig mit Metall beschichtetes Keramiksubstrat ist.

Der Kühlkörper kann unterschiedlich ausgebildet sein. Die unterschiedlichen Ausbildungen sind dem Fachmann bekannt.

Der gegenüber PCB basierten Solarmodulen geringere thermische Widerstand zwischen der mit Solarzellen bestückten Oberseite und der als Kühlfläche wirkenden Unterseite des beidseitig beschichteten Keramiksubstrates verbessert die Wärmeleitung zum Kühlkörper und damit die Kühlung des Solarmoduls.

Des Weiteren reduziert der gegenüber PCB basierten Solarmodulen geringere Temperaturausdehnungskoeffizient des Trägersubstrates die Verformungen des Gesamtsystems. Zugleich erhöht sich dadurch die Lastwechselfähigkeit des Gesamtsystems und damit auch die Lebensdauer.

In einer bevorzugten erfindungsgemäßen Ausführungsform ist das Trägersubstrat aus Keramik beidseitig mit Kupfer beschichtet (DCB-Substrat; Direct Copper Bonding).

In einer alternativen erfindungsgemäßen Ausführungsform ist das Trägersubstrat aus Keramik beidseitig mit Aluminium beschichtet (DAB-Substrat; Direct Aluminum Bonding).

Eine weitere bevorzugte Ausführungsform der Erfindung weist eine geteilte Metallbeschichtung und somit eine Vielzahl von Metallinseln auf der Oberseite des Keramiksubstrates auf.

Zudem sind die metallbeschichtete Ober- und Unterseite des Trägersubstrates aus Keramik in einer weiteren bevorzugten Ausführungsform des Solarmoduls vernickelt. Die Metallveredelung durch Vernickelung gewährt eine bessere Oberflächengüte, so dass die Solarzellen mit ihrer Unterseite gänzflächig aufgelötet werden können.

Durch die Erhöhung der thermischen Leitfähigkeit eignet sich die erfindungsgemäße Ausführungsform des Solarmoduls bei thermischer Ankopplung an einen Kühlkörper auch für den Einsatz in sogenannten Konzentratoranwendungen.

In einer bevorzugten Ausführungsform der Erfindung ist der die Solarzellen abdeckende transparente Kunststoff zur Leistungssteigerung des Solarmoduls mit optischen Hilfsmitteln versehen, durch die das einfallende Licht um ein Vielfaches verstärkt wird.

Im folgenden wird ein Ausführungsbeispiel der Erfindung anhand einer Zeichnung näher beschrieben.

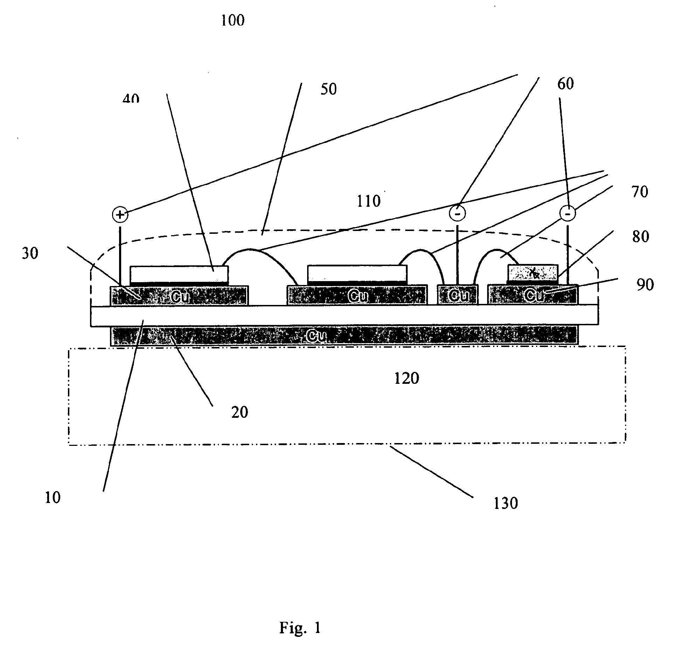

Fig. 1 zeigt den Aufbau eines Solarmoduls **(100)** mit beidseitig mit Metall beschichtetem Trägersubstrat **(10)** aus Keramik. Die Metallbeschichtung der Oberseite ist dabei aus Kupfer und geteilt ausgeführt, so dass die Oberfläche viele kleine Metallinseln aus Kupfer aufweist. Auf der Oberseite des Trägersubstrates sind die Solarzellen **(40)** ganzflächig auf die Metallschicht (Metallinseln) des Keramiksubstrates gelötet. Die Lötschicht hat das Bezugszeichen **(90).** Die einzelnen auf den Metallinseln liegenden Solarzellen sind mittels Bonddrähten **(70)** seriell verschaltet. Durch externe Anschlüsse lassen sich Solarmodule parallel oder in Serie schalten. Ferner ist ein Halbleiterbauelement, in diesem Fall eine Schottky-Diody **(80),** auf einer Metallinsel auf der Oberfläche des Trägersubstrates angebracht. Das Solarmodul ist mit einer transparenten die Solarzellen abdeckenden Kunststoffschicht **(50)** vergossen, aus der auf das DCB-Substrat gelötete und nach Außen geführte elektrische Anschlüsse **(60)** herausragen. Zur Kühlung ist das Solarmodul an der als Kühlfläche fungierenden Unterseite mit einem Kühlkörper **(130),** der hier nur schematisch dargestellt ist, verbunden.

Zusammenfassend weist das erfindungsgemäße Solarmodul gegenüber PCB basierten Solarmodulen einen geringeren thermischem Widerstand und dadurch bedingt eine bessere Wärmeleitung des Gesamtsystems bei der thermischen Ankopplung an einen Kühlkörper an der als Kühlfläche fungierenden ebenen Unterseite des Solarmoduls auf. Dadurch bedingt erhöht sich die Temperaturwechselfestigkeit des Gesamtsystems. Aufgrund der verbesserten thermischen Leitfähigkeit eignen sich derartig ausgebildete Solarmodule auch für den Einsatz in sogenannten Konzentratoranwendungen, in denen das einfallende Licht zum Zwecke der Steigerung der Ausgangsleistung von Solarmodulen mit optischen Elementen um ein vielfaches verstärkt wird. Der gegenüber PCB basierten Solarmodulen geringere Temperaturausdehnungskoeffizient des Trägersubstrates bedingt eine geringere Verformungstendenz des Gesamtsystems. Insgesamt wird in Verbindung mit einer verbesserten Wärmeleitung des Solarmoduls dessen Lebensdauer erhöht.

## Patentansprüche

1. Solarmodul, aufweisend ein Trägersubstrat **(10)** mit einer Anordnung von mindestens einer Solarzelle **(40)** auf der Oberseite **(110)** des Trägersubstrates, die mit einem transparenten, die Solarzelle abdeckenden, Kunststoff **(50)** vergossen ist, und eine als Kühlfläche fungierende ebene Unterseite **(120)** zur thermischen Ankopplung an einen Kühlkörper **(130), dadurch gekennzeichnet, dass** das Trägersubstrat ein beidseitig mit Metall beschichtetes Keramiksubstrat ist.

2. Solarmodul nach Anspruch 1, **dadurch gekennzeichnet, dass** das Trägersubstrat **(10)** eine Kupferbeschichtung **(20, 30)** aufweist (DCB-Substrat; Direct Copper Bonding).

3. Solarmodul nach Anspruch 1, **dadurch gekennzeichnet, dass** das Trägersubstrat **(10)** eine Aluminiumbeschichtung **(20, 30)** aufweist (Al-Direct Bonding).

4. Solarmodul nach Anspruch 1, **dadurch gekennzeichnet, dass** die Metallbeschichtung **(20, 30)** auf der Oberseite **(110)** des Keramiksubstrates geteilt ausgeführt ist.

5. Solarmodul nach Anspruch 2, **dadurch gekennzeichnet, dass** die beidseitige Kupferschicht **(20, 30)** des Keramiksubstrates **(10)** vernickelt ist.

6. Solarmodul nach Anspruch 1, **dadurch gekennzeichnet, dass** der Kunststoff **(50)** optische Hilfsmitteln aufweist.

7. Anordnung von einem Solarmodul **(100)** nach einem der Ansprüche 1 bis 6 und einem Kühlkörper **(130),** wobei das Solarmodul an der als Kühlfläche fungierenden ebenen Unterseite **(120)** mit dem Kühlkörper **(130)** verbunden ist.
